(19) Europäisches Patentamt

European Patent Office

Office européen des brevets

(11) Publication number: **0 115 381**
**B1**

(12) **EUROPEAN PATENT SPECIFICATION**

(45) Date of publication of patent specification: **20.04.88**

(51) Int. Cl.⁴: **B 62 D 15/02**, B 62 D 5/00

(21) Application number: **84300080.3**

(22) Date of filing: **06.01.84**

(54) **Apparatus for detecting the angular position and angular velocity of a rotatable member and a method of assembling the apparatus.**

(30) Priority: **29.01.83 JP 11958/83**

(43) Date of publication of application:
**08.08.84 Bulletin 84/32**

(45) Publication of the grant of the patent:
**20.04.88 Bulletin 88/16**

(84) Designated Contracting States:
**DE FR GB IT**

(56) References cited:
**DE-A-3 106 088**
**GB-A-2 024 122**

(73) Proprietor: **TOYOTA JIDOSHA KABUSHIKI KAISHA**
**1, Toyota-cho Toyota-shi**
**Aichi-ken 471 (JP)**

(72) Inventor: **Hoshino, Shigeru**
**161 Banchi 1-Chome, Ohbayashi-cho**
**Toyota-shi Aichi-ken (JP)**
Inventor: **Miyata, Hiroshi Dai 2 Ekaku Apart.**
**B917**
**56 Banchi 2-Chome, Ekakushinmachi**
**Toyota-shi Aichi-ken (JP)**

(74) Representative: **Ben-Nathan, Laurence Albert et al**
**Urquhart-Dykes & Lord 91 Wimpole Street**
**London W1M 8AH (GB)**

EP 0 115 381 B1

Courier Press, Leamington Spa, England.

## Description

The present invention relates to an apparatus for detecting an angular position and an angular velocity of a rotatable member and a method of assembling it, and particularly to a steering sensor for detecting a steering angle and a steering angular velocity.

Heretofore, an apparatus for detecting a steering angle and a steering angular velocity is generally known, comprising a disc mounted on a steering shaft, and a sensor secured to a stationary steering column tube. The present applicants have described an invention concerning the way in which the sensor is mounted, in a separate Patent application. The disc is designed to be rotated with the steering shaft, and has a number of small holes which are concentrically located therein. The sensor has a light emitting element and a light receiving element, which are located on opposite sides of the disc at positions opposite the series of holes in the disc. When the steering shaft is rotated by a driver, the disc rotates with the steering shaft. In this condition, the light transmitted from the light emitting element to the light receiving element is interrupted by the rotation of the disc. The degree of the interruption is proportional to the number of the rotations of the disc. The degree of the interruption is converted to an electric pulse, and thereafter the steering angle and a steering angular velocity are calculated from the electric pulse.

It is quite difficult to assemble the disc and the sensor with a high degree of accuracy. Further, there is the possibility of adversely affecting the thin disc by contact of the thin disc with the light emitting element or the light receiving element during assembly in the steering system.

GB—A—1,417,788 describes an apparatus for generating electrical pulses for each revolution of a shaft, which has the features of the preamble of Claim 1.

The present invention was made in view of the foregoing background art. It is an object of this invention to provide an improved apparatus for detecting a steering angle and an angular velocity of a rotatable part of a steering system to overcome or minimize the aforesaid disadvantages of the known detecting apparatus whereby correct assembly is facilitated.

The invention provides an apparatus for detecting the angular position and angular velocity of a rotatable member, comprising a disc mounted on and rotatable with the rotatable member, the disc having a number of holes located around the circumference thereof, a fixed member, a sensor secured to the fixed member and having positioned on respective opposite sides of the disc, a light emitting means and light receiving means at locations opposite said holes in the disc, wherein the disc projects radially from the rotatable member towards the sensor by a distance, and the sensor is provided with extensions in which said light emitting means and said light receiving means are located, respectively, characterized in that the length of the extension provided with said light emitting means or said light receiving means being greater than the projecting distance of said portion of the disc whereby the disc is prevented from radial contact with the sensor.

The above object, features and advantages of the present invention will become more apparent from the following description of a preferred embodiment taken in conjunction with the accompanying drawings, in which:-

Fig. 1 is a perspective view of a steering system provided with an apparatus according to the present invention;

Fig. 2 is a perspective view of a steering shaft provided with detecting means according to the present invention;

Fig. 3 is an enlarged partial cross-sectional view of the embodiment of the present invention;

Fig. 4 is a partial cross-sectional view taken along the line IV—IV in Figure 3;

Fig. 5 is a reduced partial cross-sectional view taken along the line V—V in Figure 2;

Fig. 6 is a cross-sectional view taken along the line VI—VI of Figure 5;

Figs. 7(a), (b), (c) and (d) are views which illustrate the assembling steps of the disc and the sensor according to the present invention; and

Fig. 8 is a cross-sectional view which illustrates the relation between the sensor and the disc according to the present invention.

The present invention is described in detail with reference to the accompanying drawings which illustrate an embodiment of the present invention.

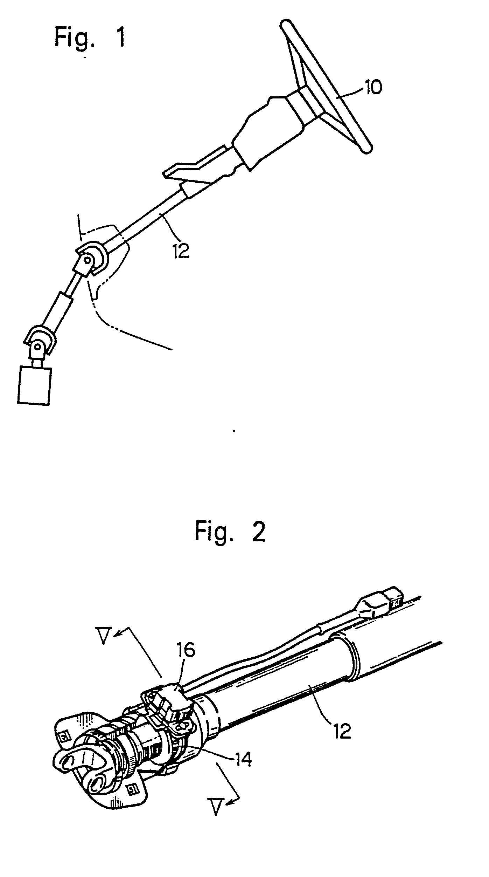

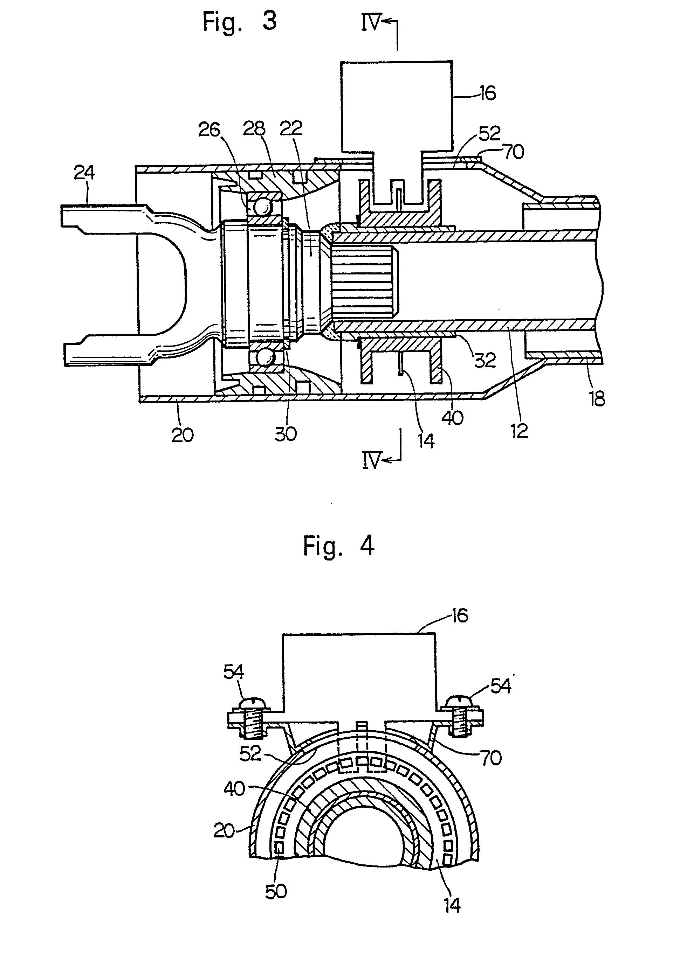

Figure 1 shows a perspective view of a steering system provided with an apparatus according to the present invention. The rotational movement of a steering wheel 10 is transmitted through a steering shaft 12 to wheels (not shown in drawings). The perspective view of the steering shaft 12 according to the present invention is shown in Figure 2. A disc 14, which includes a number of small holes concentrically located therein, is mounted on the outer periphery of the steering shaft 12. A sensor 16 is located at the outer side of the disc 14, and is secured to a steering column tube 18. Figure 3 shows an enlarged detailed cross-sectional view of the apparatus according to the present invention.

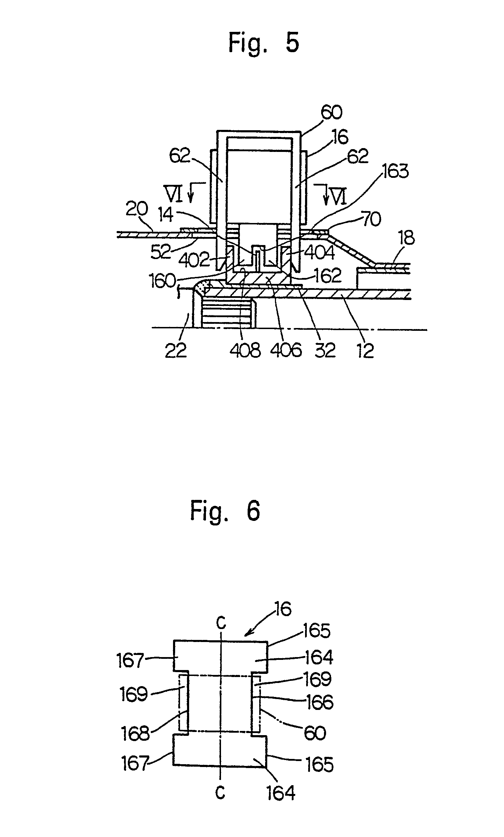

The steering column tube 18 extends downward (to the left in Figure 3), and an enlarged lower steering column tube 20 is secured to the lower portion of the steering column tube 18. The steering shaft 12 is inserted into the inside of the steering column tube 18. The upper end of the steering shaft 12 is connected with the steering wheel 10. The lower part of the steering shaft 12 extends into the inside of the lower steering column tube 20. The lower end of the steering shaft 12 is fixed by welding to a shaft portion 22 of a yoke 24. A lower bearing 26 is provided on the outer periphery of the shaft portion 22 of the yoke 24. The lower bearing 26 is secured through a retainer 28 to the inner face of the lower steering column tube 20. A snap ring 30, provided on the outer periphery of the shaft portion 22 of the yoke 24, prevents the lower bearing 26 from slipping out. A collar 32 fits into the outer periphery of the steering shaft 12 and is welded to the steering shaft 12. A holder 40 is press fitted onto the outer periphery of the collar 32. The holder 40 has a U-shaped cross-sectional form. The holder 40 is to hold the disc 14 thereon. Figures 5 through 8 illustrate the detailed structure of the holder 40. The holder 40 has side walls 402 and 404, and a tubular portion 406 which connects the side walls 402 and 404. The disc 14 is secured to the longitudinal central point of the outer surface 408 of the tubular portion 406. The disc 14, as shown in Figure 4, includes a number of small holes 50, which are of the same form and are positioned concentrically with respect to the axis of the disc 14 at regularly spaced intervals. The lower steering column tube 20 has an aperture 52 at a position which faces the holder 40. The aperture 52 is square. The lower portion of the sensor 16 extends through the aperture 52 into the inside of the lower steering column tube 20. The sensor 16 is fastened by screws 54 to a sensor mounting bracket 70. The bracket 70 is fixed to the lower steering column tube 20, as shown in Figure 4.

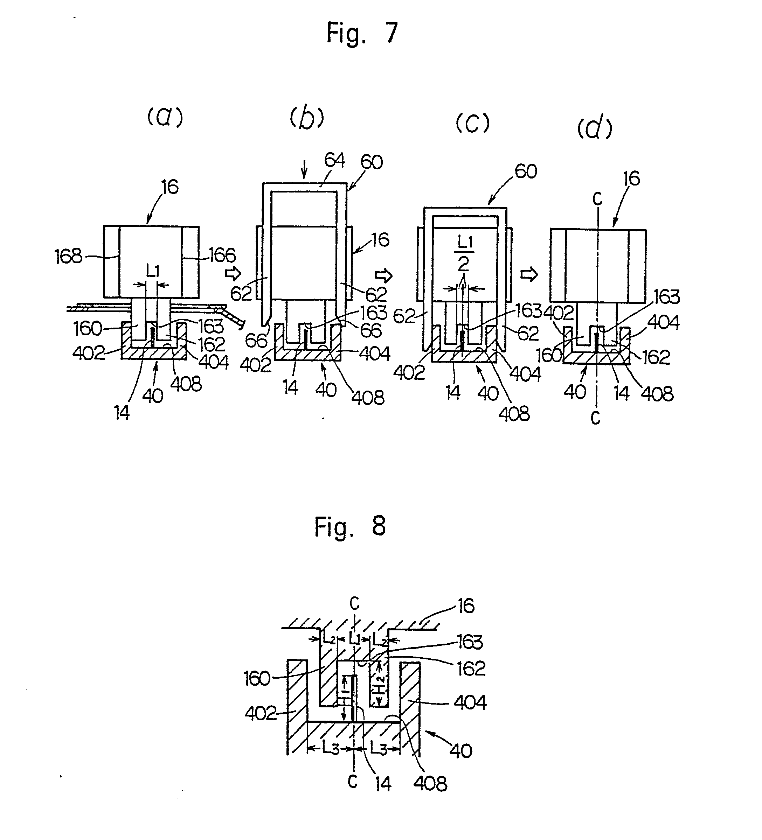

The disc 14 is designed to have a shorter height "$H_1$" than the height of the side walls 402 and 404 of the holder 40 as shown in Figure 8.

The sensor 16, as shown in Figures 6 and 7, has a main portion 164 of a hexagonal cross-sectional form, a light emitting element 160, and a light receiving element 162, both of which are secured to the under surface of the main portion 164. The light emitting element 160 and the light receiving element 162 are separated from each other by a distance "$L_1$". The disc 14 is located on the central point of the distance "$L_1$". The sensor 16, as shown in Figure 6, has front side faces 165, a front intermediate side face 166, rear side faces 167, and a rear intermediate side face 168. The sensor 16 is symmetrical with regard to a central plane "C—C" shown in Figure 6. The distance between the front intermediate side face 166 and the rear intermediate side face 168 is designed to be substantially the same as that defined between the outer faces of the side walls 402 and 404 of the holder 40. The light emitting element 160 and the light receiving element 162 are provided at the symmetrical positions with regard to a central plane "C—C" through the sensor 16 shown in Figure 7(d). The light emitting element 160 is designed to have the same thickness as that of the light receiving element 162. There is provided a groove between the light emitting element 160 and the light receiving element 162, whose distance is "$L_1$".

The numeral 60, shown in Figures 6 and 7, designaates a jig for avoiding contact of the thin disc 14 with the light emitting element 160 or the light receiving element 162 when assembling the sensor 16 in the correct position. The jig 60 has a pair of legs 62, and a bridge portion 64 which connects one of the legs 62 with the other leg. The pair of legs 62 extend in parallel with each other.

The jig 60 has a cross-sectional form of a U-shape. The distance between the inner faces of the legs 62 is designed to be the same as that defined between the front intermediate side face 166 and the rear intermediate side face 168 of the sensor 16. As the distance between the front intermediate side face and the rear intermediate side face 168 of the sensor 16 is designed to be the same as that defined between the outer faces of the side walls 402 and 404, the distance between the inner faces of the legs 62 is designed to be the same as that defined between the outer faces of the side walls 402 and 404. Each of the legs 62 has a tip end 66 which is inclined outward, and each of the tip ends is oppositely inclined. Each of the legs 62 of the jig 60 is fitted onto the outer face of the side walls 402 or 404 of the holder 40, thereby the jig 60 tightly grips the holder 40.

The references as to the length of the sensor 16 and the holder 40 are shown in Figure 8. The reference $L_1$, is the distance between the light emitting element 160 and the light receiving element 162. The reference $L_2$, is the width or thickness of the light emitting element 160 and of the light receiving element 162. The reference $L_3$, is the distance between the disc 14 and the side walls 402 or 404 of the holder 40. The height of the disc 14 is indicated by the reference "$H_1$". The light emitting element 160 and the light receiving element 162 project toward the holder 40 by the distance "$H_2$". The embodiment according to the present invention has the following relation:

$$L_1 + L_2 > L_3 \qquad (1)$$

$$H_2 > H_1 \qquad (2)$$

Due to the above relationship (1), even when the outer face of the light emitting element 160 contacts with the inner face of the side wall 402 as shown in Figure 7(a), the light receiving element 162 does not contact the disc 14. Further, even when the outer face of the light receiving element 162 contacts with the inner face of the side wall 404, the light emitting element 160 does not contact the disc 14.

Due to the above relationship (2), even when the lower ends of the light emitting element 160 and the light receiving element 162 contact the outer surface 408 of the holder 40, the top end of the disc 14 does not contact the under surface 163 of the sensor 16.

The sensor 16 is assembled into the steering system according to the following procedure: at first, the sensor 16 is held such that the light emitting element 160 contacts the inner face of the side wall 402 of the holder 40, as shown in Figure 7(a). Next, the jig 60 is inserted from above onto the sensor 16, and the legs 62 of the jig 60 fit into grooves 169 defined in the sensor 16 shown in Figure 6. One of the inclined low ends of the legs 62 contacts with the outer periphery of the top end of the side wall 404 as shown in Figure 7(b), thereafter both legs 62 are forced to move downwards while keeping the contact with the outer surfaces of the side walls 402 and 404. The central face "C—C" of the sensor 16 becomes coincident with the plane of the disc 14. The sensor 16 is fastened by the sensor bracket 70 to the lower column tube 20 by screws 54 as shown in Figure 4. Finally, the jig 60 is removed from the sensor 16.

When the sensor 16 is assembled in the steering column, the disc 14 does not contact the light emitting element 160 or the light receiving element 162. Hence, the disc 14 is not damaged during assembly of the steering system. The sensor 16 can therefore detect accurately the steering angle and the steering angular velocity. Workers can promptly assemble the sensor into the steering column by the use of the jig. Further, the jig can protect the disc from being adversely affected by striking the light emitting element or the light receiving element when the steering column is transferred.

While the present invention has been described in its preferred embodiment, it is to be understood that the invention is not limited thereto, and other embodiments are possible within the scope of the following claims.

Reference is made to European Patent Application 0,218,308 which describes and claims an apparatus for detecting the angular position and angular velocity of a rotatable member which is contructed in accordance with the above-mentioned relationship (1).

## Claims

1. An apparatus for detecting the angular position and angular velocity of a rotatable member (12), comprising a disc (14) mounted on and rotatable with the rotatable member (12), the disc (14) having a number of holes (50) located around the circumference thereof, a fixed member (20), a sensor (16) secured to the fixed member (20) and having positioned on respective opposite sides of the disc, a light emitting means (160) and light receiving means (162) at locations opposite said holes (50) in the disc (14), wherein the disc (14) projects radially from the rotatable member (12) towards the sensor (16) by a distance (H₁), and the sensor (16) is provided with extensions in which said light emitting means (160) and said light receiving means (162) are located, respectively, characterized in that the length $(H_2)$ of the extension provided with said light emitting means (160) or said light receiving means (162) being greater than the projecting distance $(H_1)$ of said portion of the disc (14) whereby the disc (14) is prevented from radial contact with the sensor (16).

2. An apparatus according to Claim 1 for detecting a steering angle and a steering angular velocity of a rotatable part of a steering system mounted on a vehicle, comprising a steering wheel (10), a steering shaft (12) to which the steering wheel (10) is connected at one end thereof, said disc (14) being mounted on and rotatable with the steering shaft (12), and a steering column tube (18) in which the steering shaft (12) is rotatably mounted, said sensor (16) being mounted on said steering column tube (18).

3. An apparatus as claimed in Claim 2, wherein the apparatus further comprises a holder (40) secured to the outer periphery of the steering shaft (12), the holder (40) having the disc (14) secured thereto at a central position along the length of the holder (40).

4. An apparatus as claimed in Claim 3, wherein the holder (40) comprises a first side wall (402) extending towards the sensor (16), a second side wall (404) extending towards the sensor (16) in a parallel relationship with the first side wall (402), the side walls (402, 404) being spaced apart at a distance $(2L_3)$, and a tublar portion (406) which connects the first side wall (402) and the second side wall (404), the disc (14) being secured to the holder (40) centrally of the tubular portion (406).

5. An apparatus as claimed in Claim 4, wherein each of said extensions of the sensor (16) have a width $(L_2)$, and they are spaced apart by a distance $(L_1)$, wherein the following relationship exists:-

$$L_1 + L_2 > L_3$$

6. A method of assembling the sensor (16) of an apparatus as claimed in Claim 5 in a steering system adjacent the disc (14) thereof, the method comprising the steps of:

contacting an outer surface of one of said extensions of the sensor (16) with an inner surface of a side wall (402, 404) of said holder (40) mounted on the steering shaft (12);

fitting a jig (60) having a pair of legs (62, 62), which are separated by a distance which is the same as that between the outer faces of the side walls (402, 404) of the holder (40), onto the outer surfaces of the sensor (16);

moving the sensor (16) fitted with the jig (60) towards the holder (40); and

removing the jig (60) after the sensor (16) is correctly positioned, in relation to the disc, in the steering system.

## Patentansprüche

1. Eine Vorrichtung zur Ermittlung der Winkelstellung und Winkelgeschwindigkeit eines drehbaren Elements (12), die eine am drehbaren Element (12) befestigte und mit diesem drehbare scheibe (14) umfaßt, wobei die Scheibe (14) eine Reihe entlang ihres Umfangs angeordneter Löcher (50) aufweist, sowie ein feststehendes Element (20) und einen an dem feststehenden Element (20) befestigten Sensor (16), der auf den jeweils gegenüberliegenden Seiten der Scheibe eine lichtemittierende Vorrichtung (160) und eine lichtempfangende Vorrichtung (162) hat, die gegenüber den genannten Löchern (50) in der Scheibe (14) angeordnet sind, wobei die Scheibe (14) radial vom drehbaren Element (12) weg und unter Wahrung eines Abstandes $(H_1)$ auf den Sensor (16) zu verläuft, und wobei der Sensor (16) Verlängerungen aufweist, in denen sich die genannte lichtemittierende Vorrichtung (160) bzw. die genannte lichtempfangende Vorrichtung (162) befindet, dadurch gekennzeichnet, daß die Länge ($H_2$) der mit der genannten lichtemittierenden Vorrichtung (160) oder der genannten lichtempfangenden Vorrichtung (162) versehenen Verlängerung größer ist als der Abstand ($H_1$), um den der genannte Abschnitt der Scheibe (14) hervorragt, womit verhindert wird, daß die Scheibe (14) radial mit dem Sensor (16) in Berührung kommt.

2. Eine Vorrichtung gemäß Anspruch 1 zur Ermittlung eines Lenkwinkels und einer Lenkwinkelgeschwindigkeit eines drehbaren Teils eines in einem Fahrzeug montierten Lenksystems, umfassend ein Lenkrad (10), sowie eine Lenkwelle (12), die an einem ihrer Enden mit dem Lenkrad (10) verbunden ist, wobei die genannte Scheibe (14) an der Lenkwelle (12) befestigt und mit dieser drehbar ist, und ein Lenksäulenrohr (18), in dem die Lenkwelle (12) drehbar montiert ist, wobei der genannte Sensor (16) am genannten Lenksäulenrohr (18) montiert ist.

3. Eine Vorrichtung gemäß Anspruch 2, wobei die Vorrichtung außerdem eine am äußeren Umfang der Lenkwelle (12) befestigte Halterung (40) umfaßt, wobei an der Halterung (40) in der Mitte der Längsabmessung dieser Halterung (40) die Scheibe (14) befestigt ist.

4. Eine Vorrichtung gemäß Anspruch 3, wobei die Halterung (40) eine auf den Sensor (16) zu verlaufende erste Seitenwand (402) sowie eine auf den Sensor (16) zu verlaufende und parallel zur ersten Seitenwand (402) angeordnete zweite Seitenwand (404) aufweist, wobei die Seitenwände (402, 404) in einem Abstand ($2L_3$) zueinander angeordnet sind, und einen rohrförmigen Abschnitt (406), der die erste Seitenwand (402) und die zweite Seitenwand (404) miteinander verbindet, wobei die Scheibe (14) an der Halterung (40) in der Mitte des rohrförmigen Abschnitts (406) befestigt ist.

5. Eine Vorrichtung gemäß Anspruch 4, wobei jede der genannten Verlängerungen des Sensors (16) eine Breite ($L_2$) aufweist, und die beiden Verlängerungen in einem Abstand ($L_1$) zueinander angeordnet sind, wobei folgende Relation vorliegt:

$$L_1 + L_2 > L_3$$

6. Eine Methode zur Montage des Sensors (16) einer Vorrichtung gemäß Anspruch 5 in einem Lenksystem in unmittelbarer Nähe der dazugehörigen Scheibe (14), wobei die Methode folgende Schritte umfaßt:

Berührung einer Außenseite einer der genannten Verlängerungen des Sensors (16) mit einer Innenseite einer Seitenwand (402, 404) der genannten, an der Lenkwelle (12) montierten Halterung (40);

Aufsetzen einer Aufspannvorrichtung (60) mit zwei Schenkeln (62, 62), die in dem gleichen Abstand wie die Außenseiten der Seitenwände (402, 404) der Halterung (40) zueinander angeordnet sind, auf die Außenseiten des Sensors (16);

Einsetzen des Sensors (16) mit der aufgesetzten Aufspannvorrichtung (60) in Richtung auf die Halterung (40); und

Entfernung der Aufspannvorrichtung (60), nachdem der Sensor (16), bezogen auf die Scheibe, im Lenksystem die richtige Position eingenommen hat.

**Revendications**

1. Un dispositif pour détecter la position et la vitesse angulaire d'un organe rotatif (12) comprenant un disque (14) monté sur et apte à tourner avec l'organe rotatif (12), le disque (14) comportant un certain nombre de trous (50) situés à sa périphérie, un organe fixe (20), un capteur (16) fixé à l'organe fixe (20) et comportant sur des faces opposées du disque, des moyens émetteurs (160) et récepteurs (162) de lumière en face desdits trous (50) dans le disque (14), dispositif dans lequel le disque (14) fait saillie radialement de l'organe rotatif (12) en direction du capteur (16) sur une distance ($H_1$), et le capteur (16) est muni de saillies dans lesquelles sont placés respectivement les moyens émetteurs (160) et récepteurs (162), caractérisé en ce que la longueur ($H_2$) de la saillie munie des moyens émetteurs (160) ou récepteurs (162) de lumière est supérieure à la distance de saillie ($H_1$) de ladite partie du disque (14), de manière que le disque (14) ne puisse pas entrer en contact radial avec la capteur (16).

2. Un dispositif selon la revendication 1, pour détecter un angle de direction et une vitesse angulaire de direction d'une partie rotative d'un système de direction monté sur un véhicule, comprenant un volant (10), un arbre de volant (12) à une extrémité duquel est relié le volant (10), ledit disque (14) étant monté sur et apte à tourner avec l'arbre de volant (12), et un tube (18) de colonne de direction dans lequel l'arbre de volant (12) est monté à rotation, ledit capteur (16) étant monté sur ledit tube de colonne de direction (18).

3. Un dispositif selon la revendication 2, comprenant en outre un support (40) fixé à la périphérie externe de l'arbre de volant (12), le support (40) comportant le disque (14) fixé sur lui en position centrale dans le sens de la longueur du support (40).

4. Dispositif selon la revendication 3, dans lequel le support (40) comprend une première paroi latérale (402) dirigée vers le capteur (16), une seconde paroi latérale (404) dirigée vers le capteur (16) parallèlement à la première paroi latérale (402), les parois latérales (402, 404) étant éloignées d'une distance ($2L_3$) et une partie tubulaire (406) reliant la première paroi latérale (402) à la seconde (404), le disque (14) étant fixé au support (40) par le centre de la partie tubulaire (406).

5. Dispositif selon la revendication 4, dans lequel lesdites saillies du capteur (16) ont chacune une largeur ($L_2$) et sont espacées d'une distance ($L_1$), la relation suivante étant satisfaite:

$$L_1 + L_2 > L_3$$

6. Un Procédé d'assemblage du capteur (16) d'un dispositif selon la revendication 5, dans un système de direction adjacent au disque (14), ce procédé comprenant les étapes consistant à:

mettre en contact une surface externe d'une desdites saillies du capteur (16) avec une surface intérieure d'une paroi latérale (402, 404) dudit support (40) monté sur l'arbre de volant (12);

glisser un gabarit (60) comportant deux bras (62, 62) écartés de la même distance que celles des faces extérieures des parois latérales (402, 404) du support (40), sur les surfaces extérieures du capteur (16);

déplacer le capteur (16) muni du gabarit (60) vers le support (40); et

retirer le gabarit (60) après le positionnement correct du capteur (16) relativement au disque dans le système de direction.

Fig. 1

10

12

Fig. 2

16

12

14

0 115 381

Fig. 3

Fig. 4

2

# Fig. 5

# Fig. 6

## Fig. 7

(a)    (b)    (c)    (d)

## Fig. 8